(19) Europäisches Patentamt

European Patent Office

Office européen des brevets

(11) **EP 1 441 038 B1**

(12) **EUROPEAN PATENT SPECIFICATION**

(45) Date of publication and mention
of the grant of the patent:
**26.04.2006 Bulletin 2006/17**

(51) Int Cl.:
*C22C 1/04* *(2006.01)*    *C23C 14/34* *(2006.01)*
*H01J 29/02* *(2006.01)*    *H01J 31/12* *(2006.01)*

(21) Application number: **04001183.5**

(22) Date of filing: **21.01.2004**

(54) **Sintered body and film forming method using the same**

Sinterkörper und Verfahren zur Herstellung eines Films unter Verwendung derselben

Corpe fritté et procédé de formation d'un film l'utilisant

(84) Designated Contracting States:
**DE FR GB IT NL**

(30) Priority: **22.01.2003 JP 2003013584**

(43) Date of publication of application:
**28.07.2004 Bulletin 2004/31**

(73) Proprietor: **CANON KABUSHIKI KAISHA**
**Ohta-ku, Tokyo (JP)**

(72) Inventor: **Sato, Toru**
**Tokyo (JP)**

(74) Representative: **TBK-Patent**
**Bavariaring 4-6**
**80336 München (DE)**

(56) References cited:
**EP-A- 1 074 639**        **US-A- 4 908 182**
**US-A- 5 976 326**        **US-A- 6 073 830**

- **KONDO SEIICHI: "Superconducting characteristics and the thermal stability of tungsten-based amorphous thin films" J MATER RES; JOURNAL OF MATERIALS RESEARCH APR 1992, vol. 7, no. 4, April 1992 (1992-04), pages 853-860, XP0009029139**

## Description

The invention relates to a sintered body and, more particularly, to a mixture sintered body of germanium (Ge) and tungsten (W) and a film forming method using such a mixture sintered.

In a flat display using electron emitting devices, as shown in Japanese Patent Application Laid-Open No. H10-284286, a spacer as an atmospheric pressure-proof structure supporting member called a spacer or rib is used in order to hold the inside of the display into a high vacuum state.

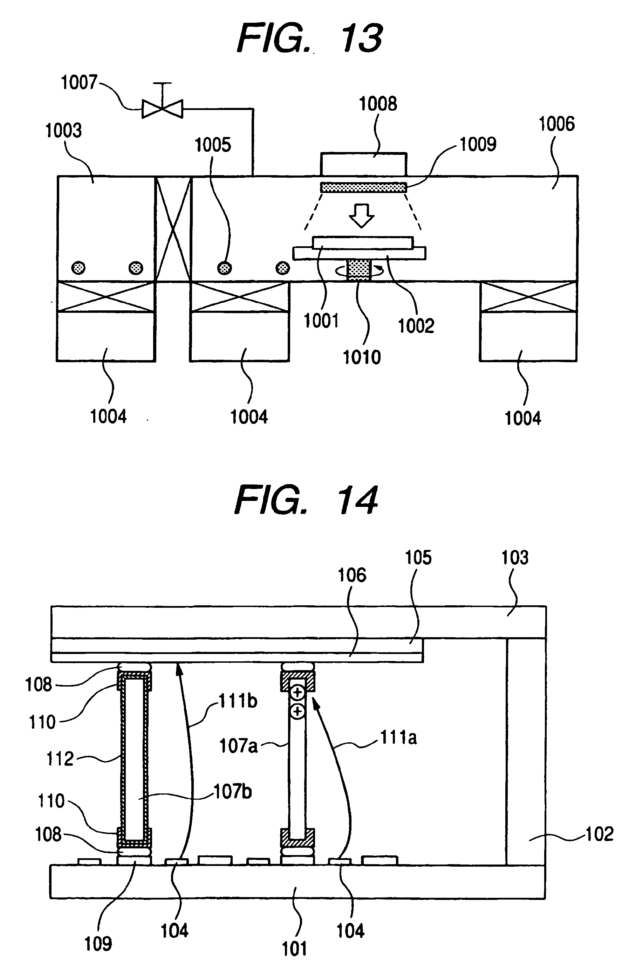

Fig. 14 is a cross sectional schematic view of an image forming apparatus using a number of electron emitting devices. Reference numeral 101 denotes a rear plate; 102 a side wall; and 103 a face plate. An airtight vessel is formed by the rear plate 101, side wall 102, and face plate 103. Low resistance films 110 are provided for a spacer 107b serving as an atmospheric pressure-proof structure supporting member of the airtight vessel. The spacer 107b is connected to a wiring 109 by a conductive frit 108.

Electron emitting devices 104 are formed on the rear plate 101. Phosphor 105 and a metal back 106 are formed on the face plate. Reasons why the metal back 106 is provided are because a part of light emitted by the phosphor 105 is reflected by a mirror surface to thereby improve light use efficiency, the phosphor 105 is protected from collision of negative ions, the metal back 106 is made to act as an electrode for applying an electron beam accelerating voltage, the phosphor 105 is made to act as a conductive path of excited electrons, and the like.

As for a spacer 107a, a charging state of the spacer is shown and a state where a part of the electrons emitted from a neighboring electron source collide with the spacer, so that charging (in the diagram, plus charging) is caused is shown. As for the spacer 107a, a charging state of the spacer in the case where an antistatic film 112 is not provided is shown. As for a thickness of low resistance film, for convenience of the diagram shown, the film is shown thicker than the low resistance film 110 which is in contact with the antistatic film 112 of the spacer 107b.

As mentioned above, when the spacer 107a is charged to the plus charges, the electrons emitted from the electron emitting devices 104 as an electron source are attracted toward the spacer side, for example, like an electron orbit 111a, so that quality of a display image is deteriorated.

To solve such a problem, there has been proposed a method whereby the antistatic film 112 is provided for the spacer 107b so that a microcurrent flows in the surface, thereby deelectrifying the spacer, and the electrons draw a predetermined locus without being attracted to the spacer as shown by an electron orbit 111b.

As shown in Japanese Patent Application Laid-Open No. 2001-143620, there has been proposed a method whereby the surface of a spacer glass substrate is formed in a coarsed state, thereby reducing an effective secondary electron emission coefficiency to a value smaller than that in the case where the spacer surface is smooth and effectively suppressing the charging on the spacer surface.

Further, in Japanese Patent Application laid-Open No. 2000-192017, there has been proposed a spacer coated with a charge relaxation film having transition metals such as chromium, germanium, and the like or their nitrides and germanium nitride by simultaneous sputtering using a chromium target and a germanium target.

However, in the spacers shown in the above prior arts, it has been clarified that a variation in performance difference occurs among the functions for deelectrifying the charges. According to the conventional methods of forming the antistatic film having a plurality of element compositions by simultaneously sputtering (for example, binary sputtering using two kinds of materials) a plurality of different material targets, there is a case where even if film forming conditions (a background, a sputter pressure, a gas flow rate, and a target inputting electric power) are equalized, a variation occurs in resistivity of the antistatic film every film forming batch.

To equalize the resistivity, it is necessary to adjust each of the target inputting electric powers which are supplied to the different material targets. Therefore, it is troublesome and reproducibility is not always high.

There is, consequently, a risk such that if the film forming process is executed plural times onto the front and back surfaces of the spacer, characteristics of the films on the front and back surfaces differ.

Document US-A-6 073 830 discloses a sputter target/backing plate assembly and method of making the same. Specifically, an improved bonded sputter target/backing plate assembly and a method of making these assemblies is described. The assembly includes a sputter target having side and bottom bonding surfaces bonded within a recess in an underlying backing plate, the recess having top and side bonding surfaces. The method of forming the bonded assembly includes treating the bonding surfaces of either the sputter target or backing plate recess by roughening at least a portion of the bonding surfaces so as to produce a roughened portion having a surface roughness ($R_a$) of at least about 120 micro-inches. The method further includes orienting the sputter target within the backing plate recess to form one assembly having a parallel interface defined by the top and bottom bonding surfaces and a side interface defined by the side bonding surfaces, subjecting the assembly to a controlled atmosphere, heating the assembly, and pressing the assembly so as to bond the bonding surfaces.

It is an object of the invention to form a resistance film having high reproducibility and excellent controllability of a resistance value.

Further, a sintered body which can form a resistance film having high reproducibility and excellent controllability of a resistance value is provided. This object is solved by what is defined in the appended independant claims. Advantageous modifications are set forth in the appended dependent claims.

Fig. 1 is a perspective view showing an image displaying apparatus according to the invention with a part of a display panel cut away;

Fig. 2 is a constructional diagram of a high frequency sputtering apparatus in which a sintered body according to the invention is disposed and which used to provide an antistatic film for a spacer base member;

Fig. 3 is a graph showing a relation between resistivity of a W-Ge mixture nitride film according to the invention and a nitrogen flow rate;

Fig. 4 is a graph showing a relation between the resistivity of the W-Ge mixture nitride film according to the invention and a sputter gas full pressure;

Fig. 5 is a graph showing a relation between a substrate conveying tray position at the time of forming the W-Ge mixture nitride film according to the invention and a DC high voltage (Vdc);

Fig. 6 is a graph showing a relation between the resistivity of the W-Ge mixture nitride film according to the invention and a W/Ge weight ratio;

Fig. 7 is a graph showing a relation between the resistivity of the W-Ge mixture nitride film according to the invention and the nitrogen gas flow rate;

Fig. 8 is a graph showing a relation between a W containing quantity and a real density of a sintered W-Ge body;

Fig. 9 is a diagram showing a variation in resistivity of the W-Ge mixture nitride film;

Fig. 10 is a diagram showing that a film formed by a mixture target is more excellent than that by a binary simultaneous sputtering with respect to a variation in resistance of the spacer for which the antistatic film according to the invention has been provided;

Fig. 11 is a diagram showing a construction of a phosphor layer;

Figs. 12A and 12B are a cross sectional view and a plan view of the coarsed spacer base member according to the invention;

Fig. 13 is a constructional diagram of a high frequency sputtering apparatus (with a substrate rotating mechanism) used to provide the antistatic film for the spacer base member according to the embodiment of the invention; and

Fig. 14 is a cross sectional schematic diagram of an image forming apparatus using electron emitting devices for explaining a charging mechanism of the spacer.

A sintered body of the invention is a sintered body characterized by containing 95 Wt% or more germanium and tungsten.

According to the sintered body of the invention, germanium and tungsten are contained as main components. Specifically speaking, 95 Wt% or more of germanium and tungsten are contained. Preferably, it is desirable that the sintered body comprises only germanium and tungsten.

The sintered body of the invention can be preferably used as a target of, particularly, a PVD (Physical Vapor Deposition) apparatus such as electron beam evaporation depositing apparatus, sputtering apparatus, or the like. If such a sintered body is used as a target of the PVD (Physical Vapor Deposition) apparatus, a resistance film having high reproducibility and excellent controllability of a resistance value can be formed.

According to the sintered body of the invention mentioned above, a weight ratio of tungsten to germanium lies within a range from 0.01 to 10, a filling factor of germanium and tungsten is equal to or larger than 60%, the sintered body is used as a target of the PVD apparatus, and the sintered body is used as a target of the sputtering. The above constructions relate to more preferable embodiments.

Another invention relates to a film forming method of a resistance film, whereby the resistance film is formed onto a substrate by sputtering the sintered body mentioned above.

According to the film forming method of the resistance film of the invention mentioned above, the resistance film having predetermined resistivity is formed by changing the weight ratio of tungsten to germanium of the sintered body, the predetermined resistivity $\rho$ is $\rho = 10^3$ to $10^9$ $\Omega$m, and the sputtering is executed in a nitrogen atmosphere. The above constructions relate to more preferable embodiments.

According to another invention, there is provided a manufacturing method of an airtight vessel supporting structure which is arranged in the airtight vessel containing an electron source and an irradiation body to which electrons emitted from the electron source are irradiated, comprising a film forming step of forming a resistance film onto a surface of a substrate, wherein the film forming step is executed by the above film forming method.

According to another invention, there is provided a manufacturing method of an electron generating apparatus in which an electron source and an irradiation body to which electrons emitted from the electron source are irradiated are provided in an airtight vessel, comprising a film forming step of forming a resistance film onto a surface of an insulating member in the airtight vessel, wherein the film forming step is executed by the above film forming method.

According to another invention, there is provided a manufacturing method of an image displaying apparatus in which an electron source and phosphor to which electrons emitted from the electron source are irradiated are provided in an airtight vessel, comprising a film forming step of forming a resistance film onto a surface of an insulating member in the airtight vessel, wherein the film forming step is executed by the above film forming method.

According to a more preferable embodiment of the manufacturing method of the image displaying apparatus mentioned above, the insulating member is the supporting structure of the airtight vessel.

The resistance film mentioned above is, for example, a film for preventing charging which is provided on the surface of the insulating member in the image displaying apparatus. Particularly, the resistance film in which desired resistance control can be made and which has high reproducibility can be formed by the above method.

Embodiments of the invention will be described hereinbelow with reference to the drawings.

First, a sputtering apparatus in which a sintered body of the invention is disposed will be described.

(Sputtering apparatus)

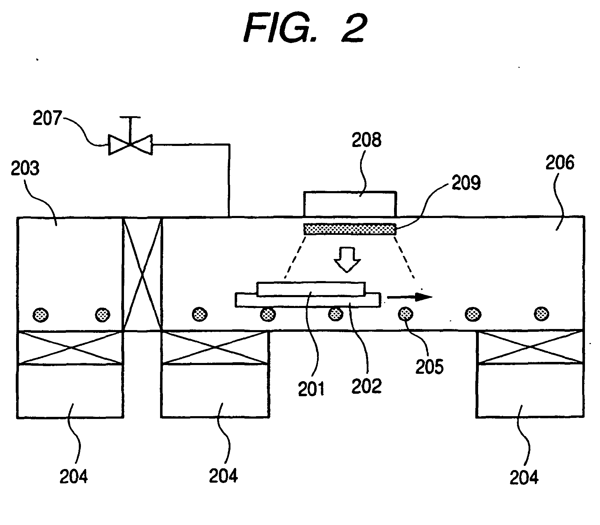

Fig. 2 shows a construction of a high frequency sputtering apparatus used in the embodiment. An outline of a process for forming a resistance film using such an apparatus will be described.

First, a substrate 201 is put onto a film forming tray 202 and inserted into a spare exhaust chamber 203. The spare exhaust chamber is exhausted to a vacuum degree of $5 \times 10^{-4}$ [Pa] or less by using vacuum pumps 204 and, thereafter, the film forming tray 202 is moved into a film forming chamber 206 by conveying rollers 205. The film forming chamber 206 is exhausted to a vacuum degree of $5 \times 10^{-5}$ [Pa] or less here. After confirming that the vacuum degree has reached a predetermined value, mixture gases of argon and nitrogen of a predetermined quantity are supplied from a gas introducing pipe 207. An orifice (not shown) is adjusted so that a sputter gas full pressure reaches a predetermined pressure. After an atmosphere (sputter gas full pressure, mixture gas flow rate) was stabilized, a predetermined electric power is applied to a high frequency power source 208. To form the resistance film onto the whole surface of the substrate 201, after the sputtering discharge was started, the film forming tray 202 is conveyed in the direction shown by an arrow in the diagram at a speed of 5 mm/min by the conveying rollers 205 so as to traverse just under a W-Ge mixture target 209. A distance between the substrate and the W-Ge mixture target is set to 200 mm.

A DC high voltage which is applied to the W-Ge mixture target 209 is adjusted by the high frequency power source 208 so as to suppress a fluctuation accompanied with the conveyance of the substrate.

The conveying direction of the substrate is not limited to one direction but the substrate can be conveyed so as to be reciprocated once or plural times. The film can be also formed onto the whole surface by rotating the substrate just under the target in dependence on the construction of the apparatus.

A W-Ge mixture nitride film can be formed onto the substrate by the above processing steps.

As an application of forming the W-Ge mixture nitride film onto the substrate, for example, in the case of using the above substrate as a spacer base member, which will be explained hereinafter, the W-Ge mixture nitride film is also formed onto the back surface of the substrate.

That is, after the film was formed onto the front surface (first surface), the film forming tray 202 is returned to the spare exhaust chamber 203 and the substrate 201 is taken out.

After the substrate 201 was front/back reversed, the W-Ge mixture nitride film is also formed onto the back surface (second surface) in a manner similar to the front surface (first surface).

By using the mixture target as mentioned above, a number of substrates each having the good resistance film can be stably manufactured.

By changing a composition density ratio of the mixture which is used as a target, the resistance film having a desired resistance range can be formed. As a method of changing the composition density ratio of the mixture, it is changed when a target material is sintered.

(Sintering method of the target)

A manufacturing method of the mixture target will be described here.

1) Mixture

First, W powder and Ge powder whose quantities have been measured in accordance with various composition density ratios are mixed. Although mixing means is not limited particularly, it is sufficient to mix them by a ball mill or the like. The mixing process is executed in a non-oxidizing atmosphere such as nitrogen gas, Ar gas, or the like. After the mixing process, they can be classified by sieving or the like as necessary.

2) Temporary sintering

The mixed powder is temporarily sintered in an inert gas atmosphere such as nitrogen gas, Ar gas, or the like or in a vacuum. It can be also temporarily sintered in a reducing atmosphere such as hydrogen or the like. Preferably, it is heated to 800 to 1500 °C and temporarily sintered.

3) Grinding

A solid matter formed as mentioned above is ground. Although grinding means is not limited in particular, it is sufficient to grind it by a ball mill or the like. The grinding is performed in the non-oxidizing atmosphere such as nitrogen gas, Ar gas, or the like. After the grinding, it can be classified by sieving or the like as necessary.

4) Actual sintering

The mixed powder obtained by the grinding is pressed and sintered in the inert gas atmosphere such as nitrogen gas, Ar gas, or the like or in the vacuum, so that a sintered body is obtained. It can be also pressed and sintered in the reducing gas atmosphere such as hydrogen or the like. It is preferable to use a hot pressing method as a method of pressing and sintering the mixed powder. A sintered body mixture target is obtained by executing the processing steps of the actual sintering such that the mixed powder is molded so as to have predetermined plate thickness and shape as a sputter target and, preferably, it is heated to 800 to 1500 °C at a pressure of 1 to 2 MPa.

As mentioned above, the sintered body mixture targets whose W/Ge weight ratio lies within a range from 0.01 to 15 was formed. Subsequently, the target of 8 atom% W and 92 atom% Ge among the sintered body mixture targets was set to the foregoing sputtering apparatus and manufacturing conditions of the W-Ge mixture nitrogen film were examined as will be explained hereinbelow.

(Determining method of nitrogen flow rate)

As another method of changing the resistivity of the resistance film, a method of changing the sputter gas full pressure at the time of forming an antistatic film or a method of changing a nitrogen flow rate can be mentioned.

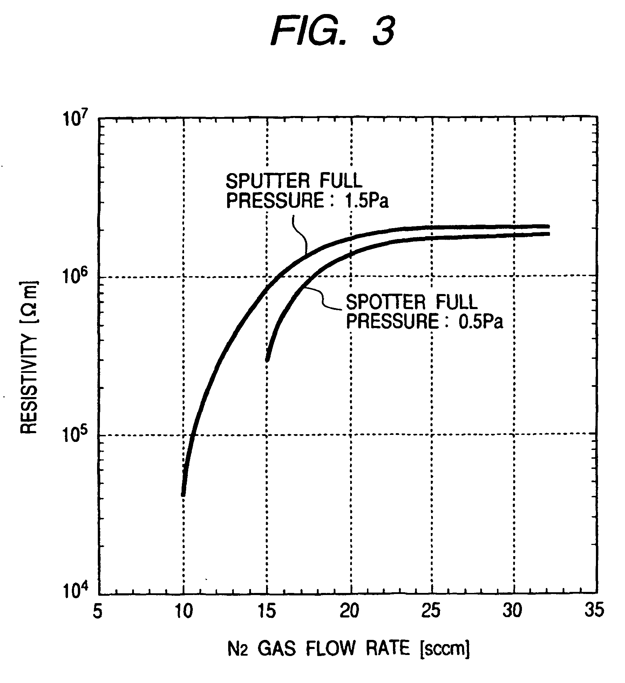

The resistivity of the W-Ge mixture nitrogen film formed by sputtering the mixture target of W and Ge (8 atom% W and 92 atom% Ge) by using the high frequency power source in each condition where the sputter gas full pressure and the nitrogen flow rate were changed was examined, so that a result as shown in Fig. 3 was obtained. The Ar flow rate was fixed to 50 sccm and the electric power applied to the W-Ge mixture was fixed to 1500W.

It will be consequently understood that by using the nitrogen flow rate of 24 sccm, the resistivity of the W-Ge mixture nitrogen film is in an area where it is insensitive to a fluctuation in nitrogen flow rate.

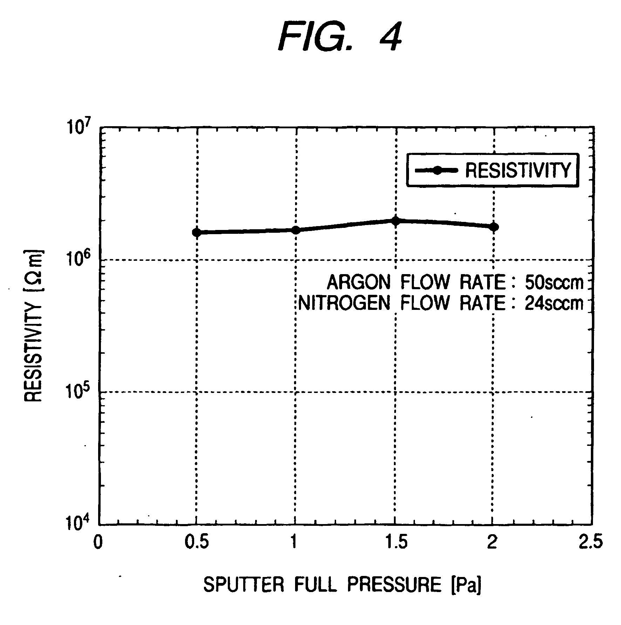

A relation between the sputter gas full pressure and the W-Ge mixture nitrogen film is as shown in Fig. 4. The flow rate of the mixed gases was fixed to argon of 50 sccm and nitrogen of 24 sccm, and the electric power applied to the W-Ge mixture was fixed to 1500W.

The substrate having those films was used as a spacer base member, the spacer was arranged near a multi-electron beam source, which will be explained hereinafter, and its deelectrifying ability was compared. Thus, the spacer with the antistatic film formed at the sputter gas full pressure of 1.5 Pa was the best.

(High DC voltage (Vdc) stabilization)

Further, in order to suppress a variation in resistance of the resistance film, a fluctuation in high DC voltage (Vdc) which is applied to the target was suppressed to a range of $\pm 20$ %.

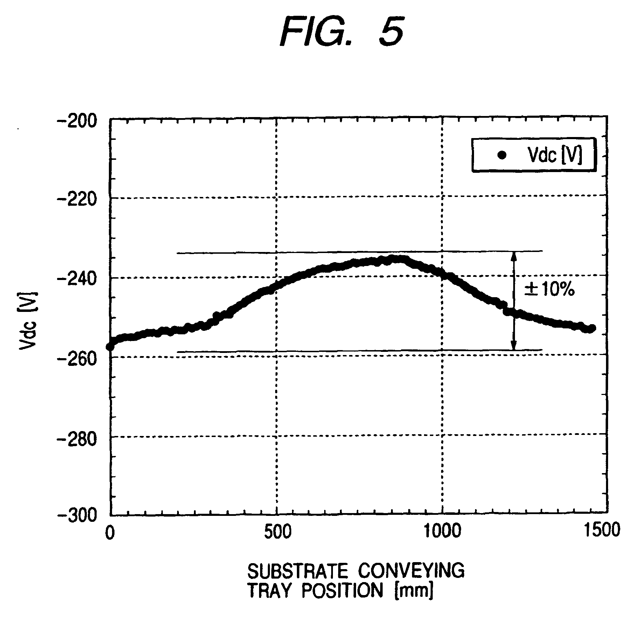

In association with the conveyance or rotation of the substrate which is executed to form the film onto the whole surface of the substrate, the high DC voltage (Vdc) fluctuated due to a change in capacitance between a sputter target and a substrate conveying tray. To prevent it, a mechanism for suppressing the fluctuation has been provided for a high frequency power source (208 in Fig. 2). Thus, a relation between the substrate conveying tray position and the high DC voltage (Vdc) is as shown in Fig. 5 and the variation in resistance of the resistance film could be suppressed.

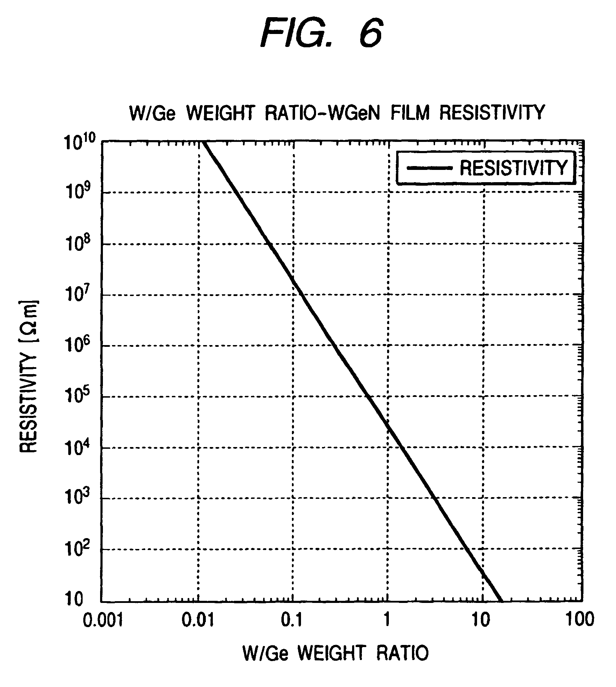

Fig. 6 shows an example of the resistivity of the W-Ge mixture nitride film formed by using the sintered body mixture target whose W/Ge weight ratio lies within a range from 0.01 to 15. It will be understood that when the W/Ge weight ratio lies within a range from 0.01 to 10, the W-Ge mixture nitride film whose resistivity lies within a range from 40 to $10^{10}$ Ωm can be obtained, and when the resistivity lies within a range from 40 to $10^{10}$ Ωm, more preferably, $10^3$ to $10^9$ Ωm, the resistivity changes in association with an increase in W and the resistance film having excellent controllability can be obtained.

A whole construction of an image displaying apparatus which uses the substrate formed with the above resistance film as a spacer and into which this spacer has been inserted will now be described.

(Panel construction)

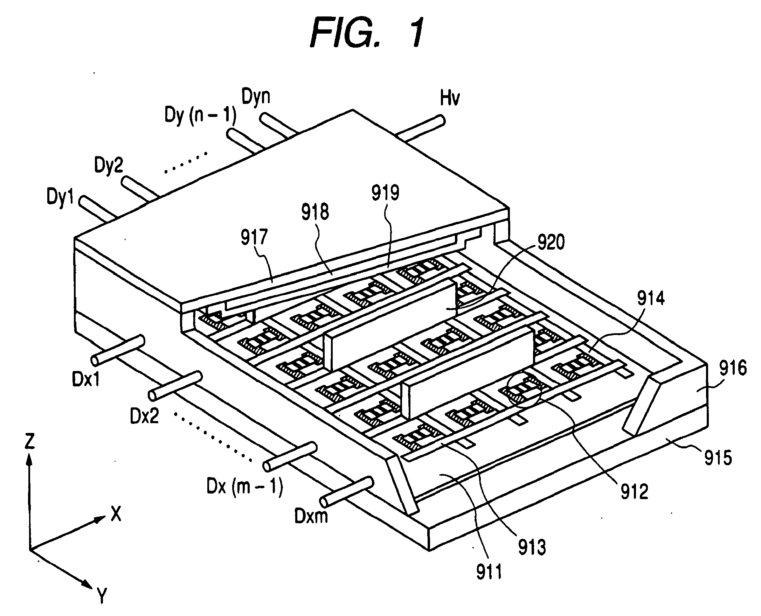

Fig. 1 a perspective view of a display panel of the image displaying apparatus of the embodiment. To show an internal structure, a part of the panel is cut away.

In the diagram, reference numeral 915 denotes a rear plate (back plate); 916 a side wall; and 917 a face plate (front plate). An airtight vessel to maintain the inside of the display panel in a vacuum state is formed by the rear plate 915, side wall 916, and face plate 917. When the airtight vessel is assembled, in order to allow a joint portion of each member to hold sufficient strength and airtight performance, it is necessary to seal them. The sealing was accomplished by, for example, a method whereby the joint portion is coated with a frit glass and they are sintered in the atmosphere or a nitrogen atmosphere at 400 to 500 °C for 10 minutes or longer. A method of exhausting the inside of the airtight vessel into a vacuum state will be described hereinafter.

Since the inside of the airtight vessel is held into a vacuum state of about $10^{-4}$ [Pa], a spacer 920 is provided as an atmospheric pressure-proof structure in order to prevent the airtight vessel from being broken by the atmospheric pressure, an unexpected shock, or the like. As such a spacer, a substrate having the resistance film using the target of the mixture (sintered body) consisting of a plurality of elements when the film is formed is used.

A substrate 911 is fixed to the rear plate 915. $(N \times M)$ surface conductivity type electron emitting devices 912 are formed on the substrate 911. N and M are positive integers of 2 or more and properly set in accordance with the target number of display pixels. For example, in a displaying apparatus to accomplish the display of a high definition television (HDTV), it is desirable to set $N \geq 3000$ and $M \geq 1000$. In the embodiment, N = 3072 and M = 1024.

The $(N \times M)$ surface conductivity type electron emitting devices are simple-matrix wired by M row direction wirings 913 and N column direction wirings 914. The portion constructed by the substrate 911, surface conductivity type electron emitting devices 912, row direction wirings 913, and column direction wirings 914 is called an electron source substrate.

A fluorescent screen 918 is formed on the lower surface of the face plate 917. A metal back 919 which is well-known in the field of the CRT is provided on the surface of the rear late side of the fluorescent screen 918.

Dx1 to Dxm, Dy1 to Dyn, and Hv denote electric connecting terminals of the airtight structure which are provided for electrically connecting the display panel to an electric circuit (not shown).

The terminals Dx1 to Dxm are electrically connected to the row direction wirings 913 of the surface conductivity type electron emitting devices. The terminals Dy1 to Dyn are electrically connected to the column direction wirings 914 of the surface conductivity type electron emitting devices. The terminal Hv is electrically connected to the metal back (metal film) 919 of the face plate.

To exhaust the inside of the airtight vessel into a vacuum state, after the airtight vessel was assembled, an exhaust pipe and a vacuum pump (which are not shown) are connected and the inside of the airtight vessel is exhausted to a vacuum degree of $10^{-5}$ [Pa] or less. After that, the exhaust pipe is sealed. To maintain the vacuum degree in the airtight vessel, a getter film (not shown) is formed at a predetermined position in the airtight vessel just before or after the sealing. The getter film is a film formed by, for example, a method whereby a getter material mainly consisting of Ba is heated, evaporation-deposited, and formed by a heater or by high-frequency heating. The inside of the airtight vessel is maintained to a vacuum degree in a range from $1 \times 10^{-3}$ to $1 \times 10^{-5}$ [Pa] owing to an adsorbing function of the getter film.

According to the image displaying apparatus using the display panel described above, when a voltage is applied to the surface conductivity type electron emitting devices 912 via the external terminals Dx1 to Dxm and Dy1 to Dyn of the vessel, electrons are emitted from the surface conductivity type electron emitting devices 912. At the same time, a high voltage in a range from hundreds of [V] to a few [kV] is applied to the metal back (metal film) 919 via the external terminal Hv of the vessel and the emitted electrons are accelerated and made to collide with the inner surface of the face plate 917. Thus, phosphor of each color constructing the fluorescent screen 918 is excited so as to emit light, so that an image is displayed.

Ordinarily, the voltage applied to the surface conductivity type electron emitting devices 912 of the invention lies within a range from about 12 to 16 [V]. A distance d between the metal back (metal film) 919 and the surface conductivity type electron emitting device 912 lies within a range from about 0.1 to 8 [mm]. The voltage across the metal back (metal film) 919 and the surface conductivity type electron emitting device 912 lies within a range from about 0.1 to 12 [kV].

The image displaying apparatus and the spacer serving as a supporting structure which is used for such an apparatus and having the resistance film (antistatic film) formed on the surface have been described above. However, according to idea of the invention, the invention is not limited to the image displaying apparatus but can be also used as an alternative light emitting source such as a light emitting diode or the like of a light printer comprising a photosensitive drum, a light emitting diode, and the like. At this time, by properly selecting the wirings from the M row direction wirings and N column direction wirings, the invention can be applied to not only a line-shaped light emitting source but also a 2-dimensional light emitting source. In this case, an irradiation body to which the electrons are irradiated is not limited to the material such as phosphor which directly emits the light but a member in which a latent image is formed by charging of the electrons can be also used. According to the idea of the invention, for example, like an electron microscope, also with respect to an apparatus in which the irradiation body of the electrons irradiated from an electron source is other than the image forming member such as phosphor or the like, the invention can be applied as an electron generating source.

Specific embodiments of the invention will be described hereinbelow. An atom% indicates a ratio of the number of monoatoms. The W/Ge weight ratio is calculated by

$$\text{(atom\% of W} \times \text{atomic weight of W)} / \text{(atom\% of Ge} \times \text{atomic weight of Ge)}.$$

(Embodiment 1)

W powder and Ge powder whose quantities have been measured so that a composition ratio is set so that W = 10 atom% and Ge = 90 atom% (W/Ge weight ratio is equal to 0.28). The mixing process is executed in a non-oxidizing atmosphere in the nitrogen gas by using the ball mill. After the mixing process, they are classified by sieving, thereby further uniforming the granular shape. The mixed powder is temporarily sintered in the vacuum.

A solid matter formed as mentioned above is ground. The grinding is performed in the non-oxidizing atmosphere in the nitrogen gas by using the ball mill. After the grinding, the granular shape is further uniformed by classifying them by sieving.

The mixed powder obtained by the grinding is pressed and sintered in the vacuum, so that a sintered body is obtained. For the pressure sintering, a hot pressing method of heating the mixed powder to 1500 °C at a pressure of 2 MPa is used. The mixed powder is molded so as to have a predetermined plate thickness and shape as a sputtering target, thereby obtaining a W-Ge sintered body mixture target. The W-Ge sintered body target has a composition of W: 21.6 Wt% and Ge:78.0 Wt%, a density of 5.32 g/cm$^3$, and a filling factor of 79%.

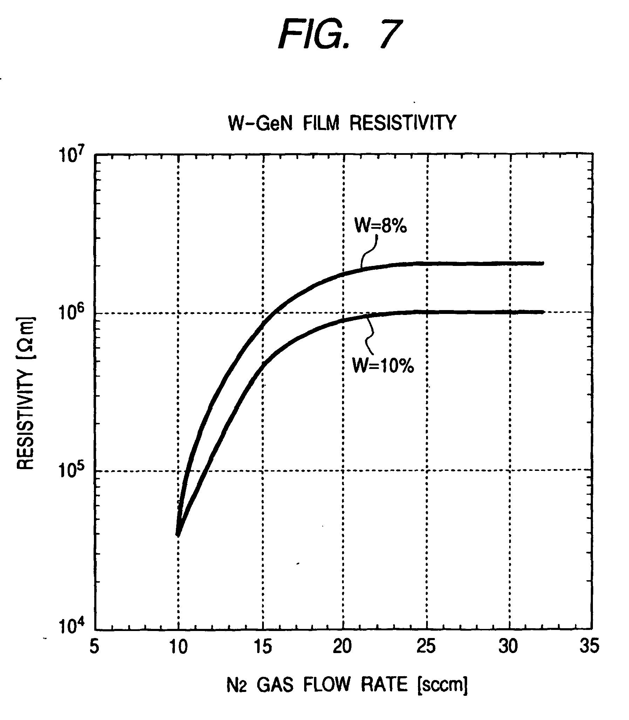

The W-Ge sintered body was set as a target of the high frequency sputtering apparatus shown in Fig. 2, the full pressure was fixed to 1.5 Pa, the Ar flow rate was fixed to 50 sccm, the $N_2$ flow rate was changed, and the W-Ge mixture nitride film was formed. Resistivity of the obtained W-Ge mixture nitride film is as shown in Fig. 7 and stabilized to $1 \times 10^6$ Ωm at an $N_2$ flow rate of 25 sccm or more.

Compositions of the W-Ge mixture nitride film formed as mentioned above were analyzed by using an RBS (Rutherford Back Scattering) method, so that the compositions were as shown in Table 1. A density of the W-Ge mixture nitride film was equal to 6.0 g/cm$^3$.

Table 1

| Film type | W containing quantity | Density according to RBS analysis (atom%) | | | | Film density (g/cm$^3$) |
|---|---|---|---|---|---|---|
| | | N | O | Ge | W | |
| W-Ge-N | W=8% | 56 | - | 40.5 | 3.5 | 5.4 |
| | W=10% | 59 | - | 36.9 | 4.1 | 6.0 |

(Embodiment 2)

In a manner similar to the embodiment 1, quantities are measured so that a composition ratio is set to W = 8 atom% and Ge = 92 atom% (W/Ge weight ratio is equal to 0.22) and the mixing process, temporary sintering, grinding, and pressure-sintering are executed, thereby obtaining the W-Ge sintered body mixture target. The W-Ge sintered body target has a composition of W:17.6 Wt% and Ge:82.0 Wt%, a density of 4.75 g/cm$^3$, and a filling factor of 74%.

A W-Ge mixture nitride film was formed in a manner similar to the embodiment 1, so that resistivity was as shown in Fig. 7 and stabilized to $2 \times 10^6$ Ωm at the $N_2$ flow rate of 25 sccm or more.

Compositions of the W-Ge mixture nitride film formed as mentioned above were analyzed by using the RBS (Rutherford Back Scattering) method, so that the compositions were as shown in Table 1. A density of the W-Ge mixture nitride film was equal to 5.4 g/cm$^3$.

(Embodiment 3)

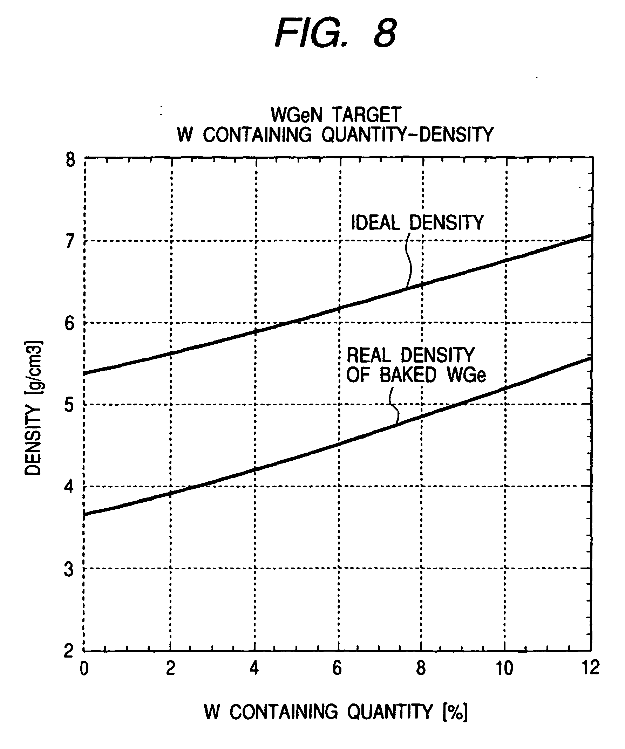

W-Ge sintered body mixture targets were formed in a manner similar to the embodiment 1 by using mixtures in which a composition ratio of W and Ge has been changed. Densities of those W-Ge sintered bodies were measured, so that they were as shown in Fig. 8. Filling factors (actually measured density/ideal density) of the W-Ge sintered bodies were equal to or larger than 60%.

(Comparison 1)

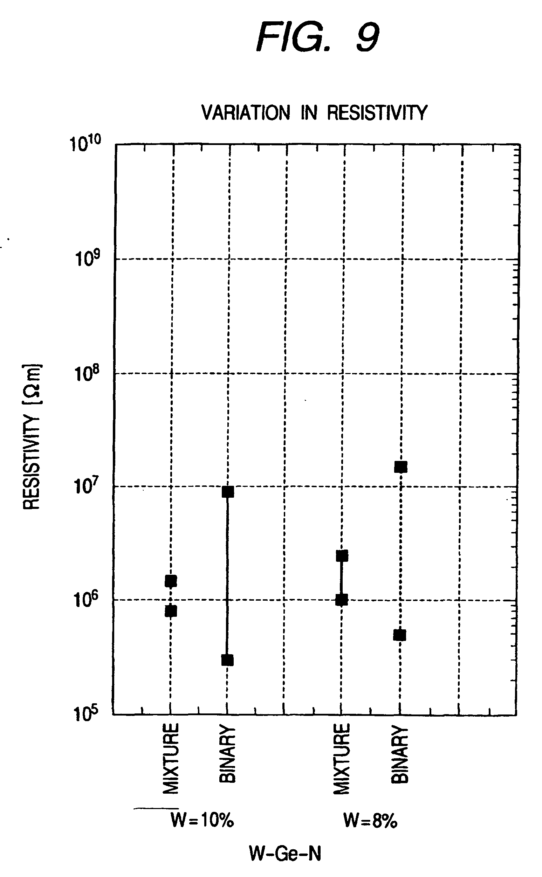

A target of mono W and a target of mono Ge are individually prepared. In a manner similar to the embodiment 1, those W target and Ge target are set as targets of the high frequency sputtering apparatus, respectively. An electric power which is applied to each of those targets was adjusted under conditions in which the full pressure is equal to 1.5 Pa, the Ar flow rate is equal to 50 sccm, and the $N_2$ flow rate is equal to 25 sccm, thereby setting the compositions of the formed film so that W = 10 atom% and Ge = 90 atom%.
The films were repetitively formed under the same conditions which have been adjusted as mentioned above, so that the resistivity of the formed W-Ge mixture nitride films varied as shown in Fig. 9.

(Comparison 2)

A target of mono W and a target of mono Ge are individually prepared. In a manner similar to the embodiment 1, those W target and Ge target are set as targets of the high frequency sputtering apparatus, respectively. An electric power which is applied to each of those targets was adjusted under conditions in which the full pressure is equal to 1.5 Pa, the Ar flow rate is equal to 50 sccm, and the $N_2$ flow rate is equal to 25 sccm, thereby setting the compositions of the formed film so that W = 8 atom% and Ge = 92 atom%.
The films were repetitively formed under the same conditions which have been adjusted as mentioned above, so that the resistivity of the formed W-Ge mixture nitride films varied as shown in Fig. 9.
In each of the embodiments, which will be explained hereinbelow, as a multi-electron beam source, there was used an electron beam source in which (N × M) (N = 3072, M = 1024) surface conductivity type electron emitting devices of the type in which the electron emitting portion is provided for the conductive film between the electrodes mentioned above are matrix-arranged by the M row direction wirings and the N column direction wirings.

(Embodiment 4)

In the embodiment, an antistatic film was formed on the surface of the spacer base member as will be explained hereinbelow.
As a spacer base member, a glass having a high melting point (PD200 made by Asahi Glass Co., Ltd.) stretched in a cross sectional shape of a rectangle of (0.2 × 1.6 mm) by the heat drawing method was cut so as to have a length 400 mm and used. This member is called a smoothed spacer base member.
The smoothed spacer base member having a length of 40 mm is cleaned by an ultrasonic wave by using a hydro carbon system detergent, acetone, and ethanol.
Subsequently, a mixture target of W and Ge (8 atom% W, 92 atom% Ge) is sputtered onto the surface of the smoothed spacer base member by using the high frequency sputtering apparatus shown in Fig. 2, thereby forming an antistatic film having a thickness of 1.5 μm. The antistatic film was subjected to RBS (Rutherford backscattering composition analysis). Then, it was revealed that the antistatic film has a composition of N:56.0 atom%, Ge:40.5 atom% and W:3.5 atom% and a density of 5.4 g/cm$^3$ as shown in the table 1.
The smoothed spacer base member 201 is put onto the film forming tray 202 and inserted into the spare exhaust chamber 203. The spare exhaust chamber is exhausted to a vacuum degree of 5 × 10$^{-4}$ [Pa] or less by using the vacuum pumps 204 and, thereafter, the film forming tray 202 is moved into the film forming chamber 206 by the conveying rollers 205. The film forming chamber 206 is exhausted to a vacuum degree of 5 × 10$^{-5}$ [Pa] or less here. After confirming that the vacuum degree has reached a predetermined value, mixture gases of argon of 50 sccm and nitrogen of 24 sccm are supplied from the gas introducing pipe 207. An orifice (not shown) is adjusted so that a sputter gas full pressure reaches 1.5 Pa. After an atmosphere (sputter gas full pressure, mixture gas flow rate) was stabilized, an electric power of 1500W is applied to the high frequency power source 208. To form the antistatic film onto the whole surface of the spacer substrate 201, after the sputtering discharge was started, the film forming tray 202 is conveyed in the direction shown by an arrow in the diagram at a speed of 5 mm/min by the conveying rollers 205 so as to traverse just under the W-Ge mixture target 209. A distance between the smoothed spacer base member and the W-Ge mixture target is set to 200 mm.
A DC high voltage which is applied to the W-Ge mixture target 209 is adjusted by the high frequency power source 208 so as to suppress a fluctuation accompanied with the conveyance of the spacer base member.

After the film was formed onto the front surface (first surface), the film forming tray 202 is returned to the spare exhaust chamber 203 and the smoothed spacer base member 201 is taken out.

After the smoothed spacer base member was front/back reversed, the W-Ge mixture nitride film is also formed onto the back surface (second surface) in a manner similar to the front surface (first surface).

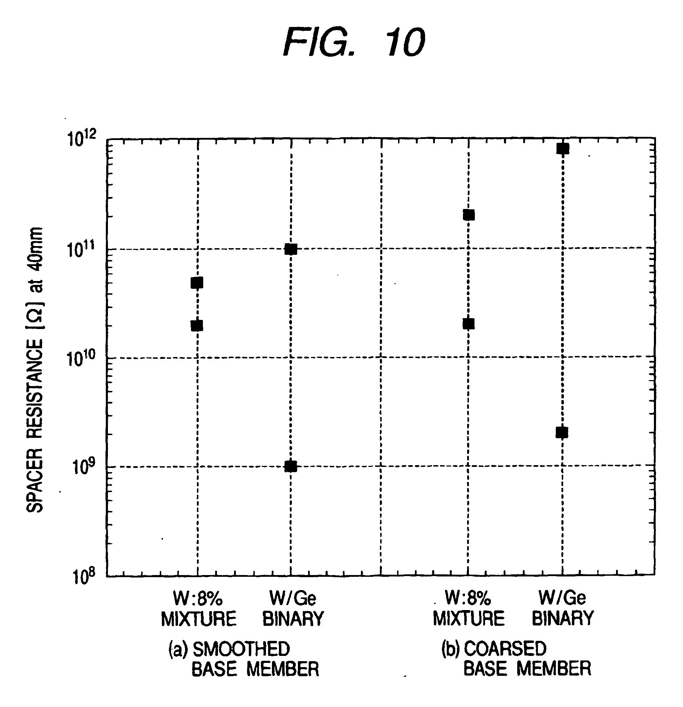

The film forming process of the W-Ge mixture nitride film as mentioned above was repetitively executed with respect to a plurality of smoothed spacer base member and the reproducibility of the resistance of each of the obtained smoothed spacers was confirmed. Thus, as compared with the case where the binary targets of W and Ge were used, by using the W-Ge mixture target, the variation in resistances can be suppressed to be smaller (Fig. 10(a)).

The display panel shown in Fig. 1 mentioned above was formed by using the smoothed spacer obtained as mentioned above.

The substrate 911 on which the row direction wiring electrodes 913, column direction wiring electrodes 914, insulating layers (not shown) between the electrodes, device electrodes of the surface conductivity type electron emitting devices, and conductive thin film have previously been formed is fixed to the rear plate 915. Subsequently, the spacer is used as a spacer 920. The face plate 917 whose inner surface has been coated with the fluorescent screen 918 and the metal back 919 is arranged at a position of 5mm above the substrate 911 via the side wall 916. The joint portions of the rear plate 915, face plate 917, side wall 916, and spacer 920 are fixed. The joint portion of the substrate 911 and the rear plate 915, the joint portion of the rear plate 915 and the side wall 916, and the joint portion of the face plate 917 and the side wall 916 are sealed by being coating with a frit glass (not shown) and sintered in the atmosphere at temperatures of 400 to 500 °C for 9 minutes or longer. On the substrate 911 side, the spacer 920 is arranged on the row direction wirings 913. On the face plate 917 side, the spacer 920 is arranged on the metal back 919 via the conductive frit glass (not shown) in which a conductive filler or a conductive material such as a metal or the like has been mixed. Simultaneously with the sealing of the airtight vessel, by sintering the spacer in the atmosphere at temperatures of 400 to 500 °C for 10 minutes or longer, it is adhered and electrically connected.

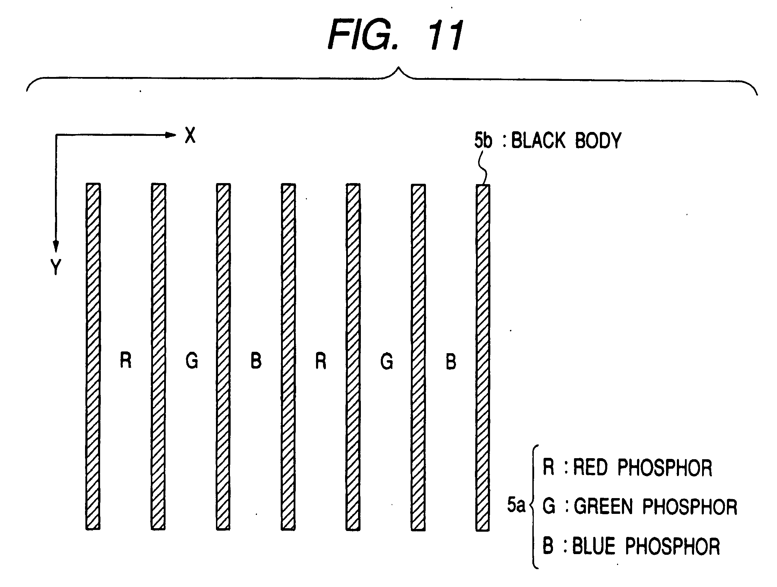

In the embodiment, as shown in Fig. 11, a fluorescent screen constructed in a manner such that phosphor 5a of each color is elongated in the column direction (Y direction) in a stripe shape and a black conductor 5b is arranged so as to separate not only the color phosphors (R, G, B) 5a but also the pixels in the Y direction is used as a fluorescent screen 918. The spacer 920 is arranged in the areas of the black conductors 5b which are in parallel with the row direction (X direction) via the metal back 919. When the sealing mentioned above is executed, since the color phosphors 5a and the devices arranged on the substrate 911 have to be made to correspond to each other, the rear plate 915, face plate 917, and spacer 920 are accurately positioned.

The inside of the airtight vessel completed as mentioned above is exhausted by the vacuum pump via an exhaust pipe (not shown). After the inside of the airtight vessel reached the sufficient vacuum degree, an electric power is supplied to each device from the external terminals Dx1 to Dxm and Dy1 to Dyn of the vessel via the row direction wirings 913 and the column direction wirings 914, respectively. By executing a current supply forming process and a current supply activating process, the multi-electron beam source is manufactured. Subsequently, by heating the exhaust pipe (not shown) by a gas burner at a vacuum degree of about $10^{-5}$ [Pa], it is melt-bonded and an envelope (airtight vessel) is sealed. Finally, the getter process is executed to maintain the vacuum degree after the sealing.

In the image forming apparatus using the display panel as shown in Fig. 1 which has been completed as mentioned above, by supplying scan signals and modulation signals to the cold cathode devices (surface conductivity type electron emitting devices) 912 from signal generating means (not shown) via the external terminals D×1 to Dxm and Dy1 to Dyn of the vessel, respectively, electrons are emitted from the devices 912. The emitted electron beam is accelerated by applying a high voltage to the metal back 919 via the high voltage terminal Hv. The electrons are made to collide with the fluorescent screen 918 and the color phosphors 5a are excited so as to emit light, thereby displaying an image. A voltage Va which is applied to the high voltage terminal Hv is set to a value within a range from 3 to 12 kV. A voltage Vf which is applied across the wirings 913 and 914 is set to 14V.

According to the image forming apparatus manufactured by the embodiment, light emitting spot trains are formed at regular intervals in a 2-dimensional shape while including the light emitting spots which are formed by the electrons emitted from the cold cathode devices 912 existing at the positions near the spacer. Thus, a clear color image having excellent color reproducibility could be displayed. This means that even if the spacer is disposed, a distortion in electric field which influences on an electron orbit did not occur.

(Embodiment 5)

In the embodiment, the antistatic film is formed on the surface of the spacer base member as will be explained hereinbelow.

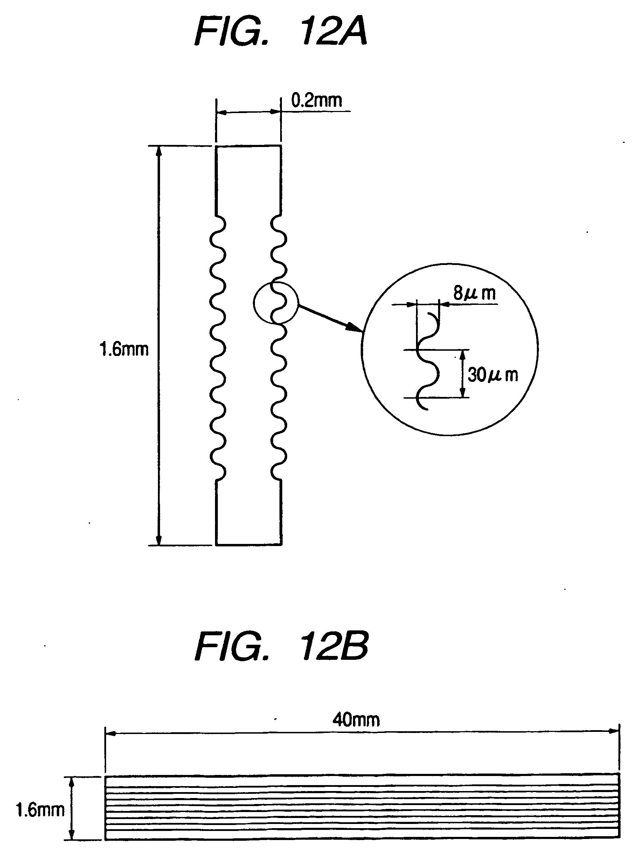

The glass having a high melting point (PD200 made by Asahi Glass Co., Ltd.) whose surface has been coarsed by a heat drawing method was used as a spacer substrate. This is because it is intended to reduce an effective secondary electron emission coefficient to a value smaller than that in the case of the smoothed spacer surface and suppress the charging of the spacer surface. External dimensions of the spacer base member are set to (0.2 × 1.6 mm) and its length is set to 40 mm in a manner similar to the embodiment 1. A period of the coarsed surface shape processed by the heat drawing method is set to 30 $\mu$m and an amplitude is set to 8 $\mu$m. Such a spacer base member is called a coarsed spacer base member. Fig. 12A shows a cross sectional view of the coarsed spacer base member and Fig. 12B shows a plan view.

Using the high frequency sputtering apparatus adjusted in a manner similar to the embodiment 1, under the same condition as in the embodiment 2, the W-Ge mixture nitride film were formed on the front and back surfaces of the coarsed spacer base member with a W and Ge mixture target (W:8 atom% and Ge:92 atom%).

The antistatic film was subjected to RBS (Rutherford backscattering composition analysis). Then, it was revealed that the antistatic film has a composition of N:56.0 atom%, Ge:40.5 atom% and W:3.5 atom% and a density of 5.4 g/cm$^3$ as shown in the table 1.

The reproducibility of the resistance of the coarsed spacer obtained as mentioned above was confirmed. Thus, as compared with the case of using the binary targets of W and Ge, the variation in resistance in the case of using the W-Ge mixture target can be more suppressed (Fig. 10(b)).

The spacer obtained as mentioned above was assembled into the image forming apparatus in a manner similar to the embodiment 1 and picture quality was evaluated. Thus, the light emitting spot trains were more uniformly formed onto the whole surface of the display screen.

(Embodiment 6)

In the embodiment, the antistatic film is formed on the surface of the spacer base member as will be explained hereinbelow.

Using the high frequency sputtering apparatus shown in Fig. 2, in a manner similar to the embodiment 1, the W-Ge mixture nitride film were formed on the front and back surfaces of the coarsed spacer base member with W and Ge mixture target (W:8 atom% and Ge:92 atom%).

The antistatic film was subjected to RBS (Rutherford backscattering composition analysis). Then, it was revealed that the antistatic film has a composition of N:56.0 atom%, Ge:40.5 atom% and W:3.5 atom% and a density of 5.4 g/cm$^3$ as shown in the table 1.

The film forming conditions are adjusted in a manner similar to the embodiment 1 and after the sputtering discharge was started, the film forming tray 202 is conveyed in the direction shown by an arrow in the diagram at a speed of 10 mm/min by the conveying rollers 205 so as to traverse just under the W-Ge mixture target 209. After that, the conveying direction is reversed and the film forming tray 202 is conveyed again in the direction opposite to the direction shown by the arrow in the diagram so as to traverse just under the W-Ge mixture target 209.

A distance between the spacer base member and the W-Ge mixture target is set to 200 mm.

The high DC voltage which is applied to the W-Ge mixture target 209 is adjusted by the high frequency power source 208 so as to suppress the fluctuation accompanied with the conveyance of the spacer base member.

By reciprocation-conveying the film forming tray 202, an effect of suppressing the variation in coated film which is caused along the coarsed shape was obtained.

The spacer obtained as mentioned above was assembled into the image forming apparatus in a manner similar to the embodiment 1 and picture quality was evaluated. Thus, the light emitting spot trains were more uniformly formed onto the whole surface of the display screen.

(Embodiment 7)

In the embodiment, the antistatic film is formed on the surface of the spacer base member as will be explained hereinbelow.

The antistatic films having a thickness of 1.5 $\mu$m were formed on the front and back surfaces of the coarsed spacer base member by sputtering the mixture target of W and Ge (8 atom% W, 92 atom% Ge) by using the high frequency sputtering apparatus having a mechanism to rotate the conveying tray shown in Fig. 13.

The antistatic film was subjected to RBS (Rutherford backscattering composition analysis). Then, it was revealed that the antistatic film has a composition of N:56.0 atom%, Ge:40.5 atom% and W:3.5 atom% and a density of 5.4 g/cm$^3$.

A coarsed spacer base member 1001 is put onto a film forming tray 1002 and inserted into a spare exhaust chamber 1003. The spare exhaust chamber 1003 is exhausted to a vacuum degree of $5 \times 10^{-4}$ [Pa] or less by using vacuum pumps 1004 and, thereafter, the film forming tray 1002 is moved into a film forming chamber 1006 by conveying rollers 1005. The film forming chamber 1006 is exhausted to a vacuum degree of $5 \times 10^{-5}$ [Pa] or less here. After confirming that the vacuum degree has reached a predetermined value, mixture gases of argon of 50 sccm and nitrogen of 24 sccm are supplied from a gas introducing pipe 1007. An orifice (not shown) is adjusted so that a sputter gas full pressure is equal to 1.5 Pa. After an atmosphere (sputter gas full pressure, mixture gas flow rate) was stabilized, an

**EP 1 441 038 B1**

electric power of 1500W is applied to a high frequency power source 1008. To form the antistatic film onto the whole surface of the coarsed spacer base member 1001, the film forming tray 1002 is rotated at a speed of 5 r.p.m. by using a tray rotating mechanism 1010. A distance between the coarsed spacer base member and the W-Ge mixture target is set to 200 mm. The high DC voltage which is applied to a W-Ge mixture target 1009 is adjusted by the high frequency power source 1008 so as to suppress a fluctuation accompanied with the rotation of the spacer base member.

After the film was formed onto the front surface (first surface), the film forming tray 1002 is returned to the spare exhaust chamber 1003 and the coarsed spacer base member 1001 is taken out.

After the coarsed spacer base member was front/back reversed, the W-Ge mixture nitride film is also formed onto the back surface (second surface) in a manner similar to the front surface (first surface).

By rotating the spacer base member, an effect of suppressing the variation in coated film which is caused along the coarsed shape was obtained.

The spacer obtained as mentioned above was assembled into the image forming apparatus in a manner similar to the embodiment 1 and picture quality was evaluated. Thus, the light emitting spot trains were more uniformly formed onto the whole surface of the display screen.

As described above, according to the invention, the resistance film having the high reproducibility and the excellent controllability of the resistance value can be easily and stably manufactured.

Therefore, in the image forming apparatus using the supporting structure (spacer) formed with the relevant resistance film, the uniform image can be formed around the spacer and the display quality can be improved.

A sintered body comprising 95 Wt% or more germanium and tungsten. The sputtering is executed by using sintered body as a target, thereby forming a resistance film to a spacer of an image forming apparatus using electron beam emitting devices and the like. Thus, the resistance film having excellent controllability and high reproducibility can be stably formed.

**Claims**

1. A sintered body containing 95 Wt% or more germanium and tungsten,
   **characterized in that**
   a weight ratio of tungsten to germanium lies within a range from 0.01 to 10.

2. A sintered body according to claim 1, wherein a filling factor of germanium and tungsten is equal to or larger than 60%.

3. A sintered body according to claim 1, wherein said sintered body is used as a target of a PVD apparatus.

4. A sintered body according to claim 3, wherein said sintered body is used as a target (209) of sputtering.

5. A film forming method of a resistance film, whereby the resistance film is formed onto a substrate (201, 1002) by sputtering the sintered body according to claim 1.

6. A method according to claim 5, wherein the resistance film having predetermined resistivity is formed by changing a weight ratio of tungsten to germanium of said sintered body.

7. A method according to claim 6, wherein said predetermined resistivity $\rho$ is $\rho = 10^3$ to $10^9$ $\Omega$m.

8. A method according to claim 5, wherein said sputtering is executed in a nitrogen atmosphere.

9. A manufacturing method of an airtight vessel supporting structure (107b, 112, 110, 108) which is arranged in the airtight vessel containing an electron source (104) and an irradiation body (105, 106) to which electrons emitted from said electron source (104) are irradiated, comprising
   a film forming step of forming a resistance film onto a surface of a substrate (201, 1002),
   wherein said film forming step is executed by the film forming method according to claim 5.

10. A manufacturing method of an electron generating apparatus in which an electron source (104) and an irradiation body (105, 106) to which electrons emitted from said electron source (104) are irradiated are provided in an airtight vessel, comprising
    a film forming step of forming a resistance film onto a surface of an insulating member (107b) in said airtight vessel,
    wherein said film forming step is executed by the film forming method according to claim 5.

**11.** A manufacturing method of an image displaying apparatus in which an electron source (104) and phosphor (105) to which electrons emitted from said electron source (104) are irradiated are provided in an airtight vessel, comprising a film forming step of forming a resistance film onto a surface of an insulating member (107b) in said airtight vessel, wherein said film forming step is executed by the film forming method according to claim 5.

**12.** A method according to claim 11, wherein said insulating member (107b) is a supporting structure of said airtight vessel.

**Patentansprüche**

**1.** Gesinterter Körper mit 95 Gew.-% oder mehr Germanium und Wolfram,
**dadurch gekennzeichnet, dass**
ein Gewichtsverhältnis von Wolfram zu Germanium innerhalb eines Bereichs von 0,01 bis 10 liegt.

**2.** Gesinterter Körper nach Anspruch 1, wobei ein Füllfaktor von Germanium und Wolfram größer oder gleich 60 % ist.

**3.** Gesinterter Körper nach Anspruch 1, wobei der gesinterte Körper bei einem PVD-Gerät als Ziel in Verwendung ist.

**4.** Gesinterter Körper nach Anspruch 3, wobei der gesinterte Körper bei einem Zerstäubungsvorgang als Ziel (209) in Verwendung ist.

**5.** Schichtausbildungsverfahren für eine Widerstandsschicht, wodurch die Widerstandsschicht auf einem Substrat (201, 1002) durch Zerstäuben des gesinterten Körpers gemäß Anspruch 1 ausgebildet wird.

**6.** Verfahren nach Anspruch 5, wobei die Widerstandsschicht mit einem vorbestimmten spezifischen Widerstand durch Ändern eines Gewichtsverhältnisses von Wolfram zu Germanium bei dem gesinterten Körper ausgebildet wird.

**7.** Verfahren nach Anspruch 6, wobei der vorbestimmte spezifische Widerstand $\rho$ bei $\rho = 10^3$ bis $10^9$ $\Omega$m liegt.

**8.** Verfahren nach Anspruch 5, wobei der Zerstäubungsvorgang in einer Stickstoffatmosphäre ausgeführt wird.

**9.** Herstellungsverfahren für eine Stützstruktur (107b, 112, 110, 108) eines luftdichten Behälters, die in dem luftdichten Behälter mit einer Elektronenquelle (104) und einem Bestrahlungskörper (105, 106) angeordnet ist, auf den von der Elektronenquelle (104) emittierte Elektronen gestrahlt werden, mit
einem Schichtausbildungsschritt zum Ausbilden einer Widerstandsschicht auf einer Oberfläche eines Substrats (201, 1002),
wobei der Schichtausbildungsschritt durch das Schichtausbildungsverfahren gemäß Anspruch 5 ausgeführt wird.

**10.** Herstellungsverfahren eines Elektronenerzeugungsgerätes, bei dem eine Elektronenquelle (104) und ein Bestrahlungskörper (105, 106), auf den von der Elektronenquelle (104) emittierte Elektronen gestrahlt werden, in einem luftdichten Behälter bereitgestellt werden, mit
einem Schichtausbildungsschritt zum Ausbilden einer Widerstandsschicht auf einer Oberfläche eines isolierenden Elements (107b) in dem luftdichten Behälter,
wobei der Schichtausbildungsschritt durch das Schichtausbildungsverfahren gemäß Anspruch 5 ausgeführt wird.

**11.** Herstellungsverfahren für ein Bildanzeigegerät, bei dem eine Elektronenquelle (104) und ein Leuchtstoff (105), auf den von der Elektronenquelle (104) emittierte Elektronen gestrahlt werden, in einem luftdichten Behälter bereitgestellt werden, mit
einem Schichtausbildungsschritt zum Ausbilden einer Widerstandsschicht auf einer Oberfläche eines isolierenden Elements (107b) in dem luftdichten Behälter,
wobei der Schichtausbildungsschritt durch das Schichtausbildungsverfahren gemäß Anspruch 5 ausgeführt wird.

**12.** Verfahren nach Anspruch 11, wobei das isolierende Element (107b) eine Stützstruktur des luftdichten Behälters ist.

**Revendications**

**1.** Corps fritté contenant 95 % en poids ou plus de germanium et de tungstène,

**caractérisé en ce que**
le rapport en poids du tungstène au germanium est compris dans une plage de 0,01 à 10.

2. Corps fritté selon la revendication 1, dans lequel un facteur de remplissage du germanium et du tungstène est égal ou supérieur à 60 %.

3. Corps fritté selon la revendication 1, dans lequel ledit corps fritté est utilisé en tant que cible d'un appareil de dépôt physique en phase vapeur PVD.

4. Corps fritté selon la revendication 3, dans lequel ledit corps fritté est utilisé en tant que cible (209) de pulvérisation.

5. Procédé de formation d'un film à résistance, par lequel le film à résistance est formé sur un substrat (201, 1002) par pulvérisation du corps fritté selon la revendication 1.

6. Procédé selon la revendication 5, dans lequel le film à résistance ayant une résistivité prédéterminée est formé en modifiant le rapport en poids du tungstène au germanium dudit corps fritté.

7. Procédé selon la revendication 6, dans lequel ladite résistivité prédéterminée $\rho$ est $\rho = 10^3$ à $10^9$ $\Omega$m.

8. Procédé selon la revendication 5, dans lequel ladite pulvérisation est exécutée dans une atmosphère d'azote.

9. Procédé de fabrication d'une structure de support (107b, 112, 110, 108) pour enceinte étanche à l'air, qui est agencée dans l'enceinte étanche à l'air contenant une source d'électrons (104) et un corps d'irradiation (105, 106) qui est irradié par des électrons émis depuis ladite source d'électrons (104), comprenant
une étape de formation de film consistant à former un film à résistance sur une surface d'un substrat (201, 1002), dans lequel ladite étape de formation de film est exécutée par le procédé de formation de film selon la revendication 5.

10. Procédé de fabrication d'un appareil de génération d'électrons dans lequel une source d'électrons (104) et un corps d'irradiation (105, 106), qui est irradiée par des électrons émis depuis ladite source d'électrons (104), sont placés dans une enceinte étanche à l'air, comprenant :

    une étape de formation de film consistant à former un film à résistance sur une surface d'un élément isolant (107b) dans ladite enceinte étanche à l'air,
    dans lequel ladite étape de formation de film est exécutée par le procédé par le procédé de formation de film selon la revendication 5.

11. Procédé de fabrication d'un appareil d'affichage d'images dans lequel une source d'électrons (104) et un luminophore (105), qui est irradié par des électrons émis depuis ladite source d'électrons (104), sont placés dans une enceinte étanche à l'air, comprenant :

    une étape de formation de film consistant à former un film à résistance sur une surface d'un élément isolant (107b) dans ladite enceinte étanche à l'air,

    dans lequel ladite étape de formation de film est exécutée par le procédé de formation de film selon la revendication 5.

12. Procédé selon la revendication 11, dans lequel ledit élément isolant (107b) est une structure de support de ladite enceinte étanche à l'air.

# FIG. 1

# FIG. 2

# FIG. 3

## FIG. 4

## FIG. 5

SUBSTRATE CONVEYING
TRAY POSITION [mm]

# FIG. 6

W/Ge WEIGHT RATIO-WGeN FILM RESISTIVITY

# FIG. 7

W-GeN FILM RESISTIVITY

# FIG. 8

WGeN TARGET
W CONTAINING QUANTITY-DENSITY

# FIG. 9

VARIATION IN RESISTIVITY

# FIG. 10

(a) SMOOTHED
   BASE MEMBER

(b) COARSED
   BASE MEMBER

FIG. 11

X

5b : BLACK BODY

Y

R    G    B    R    G    B

R : RED PHOSPHOR

5a G : GREEN PHOSPHOR

B : BLUE PHOSPHOR

EP 1 441 038 B1

# FIG. 12A

# FIG. 12B

## FIG. 13

## FIG. 14